# EUROPÄISCHE PATENTANMELDUNG

(11) **EP 0 875 921 A1**
(43) Veröffentlichungstag der Anmeldung: **04.11.1998**
(21) Anmeldenummer: 97107352.3
(22) Anmeldetag: 03.05.1997
(51) Int. Cl.: H01L 21/00

(54) **Umladevorrichtung für Wafer**

(71) Anmelder: Stäubli AG Pfäffikon, 8808 Pfäffikon (CH)
(72) Erfinder: Blattner, Jakob, 8272 Ermatingen (CH); Bachmann, Rolf, 9215 Schönenberg a.d. Thur (CH); Schmid, Hans, 8135 Langnau a. Albis (CH)
(74) Vertreter: EGLI-EUROPEAN PATENT ATTORNEYS

(57) **Zusammenfassung**

Eine Umladevorrichtung (1) für in Magazinen (4) gestapelten Wafern weist erfindungsgemäss einen vertikal verschiebbaren Rahmen (8) einer Plattform (3), mit welchem der Deckel (7) der das Magazin (4) in geschlossenem Zustand umgebenden Box (3), auf. Das Magazin (4) verbleibt dabei in der ursprünglichen Position auf dem Boden (6) der Box (5) und wird anschliessend mittels einer Greifvorrichtung (17) von dieser Position aus einer Bearbeitungsanlage (2) zugeführt, in welcher die Wafer aus dem Magazin entnommen und bearbeitet werden. Erfindungsgemäss wird weiter eine Greifvorrichtung (17) vorgeschlagen, welche vorzugsweise zwei beidseits des Magazins (4) angeordnete Auslegearme (19) sowie ein an die Wafer-Ränder in Anschlag bringbares Anschlagelement (22) aufweist. Das Anschlagelement (22) weist dabei vorzugsweise zwei aus elastischem Material bestehende Lippen auf, welche mit den Wafer-Ränder in Anschlag gebracht werden können. Die erfindungsgemässe Vorrichtung erlaubt ein sehr schnelles Be- und Entladen von Wafern in resp. aus der Bearbeitungsanlage.

## Beschreibung

Die vorliegende Erfindung betrifft eine Umladevorrichtung für Wafer nach dem Oberbegriff von Anspruch 1 sowie ein Verfahren zum Betrieb einer solchen Umladevorrichtung.

Die Beschickung von Wafer-Bearbeitungsanlagen mit Wafern erfolgt herkömmlicherweise unter Verwendung von Behältern in Form von genormten Boxen. Derartige Boxen werden in Fachkreisen mit SMIF (Standard Mechanical Interface) bezeichnet. In diesen Boxen sind in der Regel eine Vielzahl von Wafern, d.h. runden Halbleiterplatten, in einem Magazin gestapelt aufbewahrt, wobei die Boxen beispielsweise einen abnehmbaren Deckel in Form einer Haube aufweisen. Die verschlossenen Boxen werden zu einer Umladevorrichtung transportiert, in welcher sie unter Einhaltung von Reinraumbedingungen geöffnet werden und die Wafer der Bearbeitungsanlage zugeführt werden. Nach der Bearbeitung der Wafer werden diese in die Haltevorrichtung der Box zurücktransportiert und die Box wird geschlossen. Anschliessend können die Boxen von der Umladevorrichtung weitertransportiert werden.

Die Boxen werden der Umladevorrichtungen herkömmlicherweise häufig manuell zu- resp. weggeführt, d.h. der Ergonomie dieser Umladevorrichtungen kommt eine grosse Bedeutung zu. Insbesondere ist in der Regel die Höhe der Zufuhr- resp. Wegführebene für die Bedienung durch den Menschen vorgegeben.

Vielfach muss bei derartigen herkömmlichen Boxen, bei welchen die Wafer horizontal im Magazin gelagert sind, und welche durch einen in vertikaler Richtung nach oben abnehmbaren, haubenförmigen Deckel verschlossen sind, vor dem eigentlichen Bearbeitungsvorgang in der Bearbeitungsanlage noch eine Schwenkbewegung der Wafer erfolgen, bevor diese beispielsweise in vertikaler Lage der Bearbeitungsanlage zugeführt werden können.

Es sind nun Umladevorrichtungen für derartige Wafer-Boxen bekannt, bei welchen die Boxen auf der Beschickungsebene auf eine vertikal verfahrbare Beschickungsplattform aufgesetzt werden. Anschliessend wird diese Beschickungsplattform zusammen mit der Box angehoben und danach die Verschlussmittel des Deckels der Box gelöst. Danach wird der Teil der Beschickungsplattform, auf welchem der Boden mit dem Magazin aufliegt, wieder abgesenkt, wobei der Deckel auf dem Rahmen der Beschickungsplattform in der angehobenen Stellung verbleibt. Mittels Greifmitteln kann nun das Magazin zusammen mit den Wafern ergriffen, verschwenkt und der Bearbeitungsanlage in vertikaler Ausrichtung zugeführt werden. In umgekehrter Weise erfolgt schliesslich die Rückführung der bearbeiteten Wafer in das Magazin, welches danach zusammen mit dem Boden der Box wieder angehoben und in den Deckel verfahren wird. Nach dem Verriegeln der Verschlussmittel zwischen dem Boden und Deckel wird die gesamte Beschickungsplattform zusammen mit der Box wieder auf die Beschickungsebene abgesenkt kann der Umladevorrichtung entnommen werden. Durch die vielen Bewegungen benötigen diese Umladevorrichtungen einerseits eine beträchtliche Zeit, um den Be- und Entladevorgang durchzuführen und andererseits werden auch grosse Massen bewegt, was einen hohen Antriebsenergiebedarf verursacht und auch zu einer Verlangsamung des ganzen Prozesses beiträgt.

Die Aufgabe der vorliegenden Erfindung bestand nun darin, eine Umladevorrichtung für in derartigen Boxen gelagerte Wafer zu finden, welche diesen Prozess schnell, einfach und zuverlässig durchführen kann. Gleichzeitig sollen selbstverständlich die ergonomischen Aspekte berücksichtigt werden und die erforderlichen Reinraumbedingungen eingehalten werden.

Diese Aufgabe wird durch die erfindungsgemässe Vorrichtung mit den kennzeichnenden Merkmalen nach Anspruch 1 gelöst.

Durch den im Vergleich mit der eingangs genannten bekannten Umladevorrichtung vereinfachten Bewegungsablauf für das Öffnen der Box und das Ergreifen und Transportieren des Magazins mit den Wafern wird vorteilhafterweise stark verkürzte Bewegungszeit erreicht, was zu kürzeren Bearbeitungszeiten der Wafer und damit zu grösseren Bearbeitungsdurchsätzen führt. Ebenfalls weist eine derartige erfindungsgemässe Vorrichtung eine höhere Lebensdauer und kleinere Verschleissanfälligkeit auf, was zu einer grösseren Wirtschaftlickkeit im Vergleich zu herkömmlichen Vorrichtungen führt.

Weiter bevorzugte Ausführungsformen der Erfindung ergeben sich aus den Merkmalen der weiteren Ansprüche 2 bis 12.

Insbesondere die Kombination des vereinfachten Bewegungsablaufes zusammen mit der bevorzugten Ausführungsform der Greifmittel erlaubt sehr hohe Be- und Entladegeschwindigkeiten der Boxen. Auch bewirkt insbesondere das Vorsehen von zwei Auslegearmen der Greifvorrichtung eine zusätzliche Stabilität beim Greif- und Transportvorgang, was sich auch in einer hohen Präzision der Positionierung des Magazins niederschlägt.

Erfindungsgemäss wird weiter ein Verfahren zum Be- und Entladen von Wafern nach Anspruch 13 oder 14 vorgeschlagen.

Ein Ausführungsbeispiel der vorliegenden Erfindung wird nachstehend anhand von Zeichnungen noch näher erläutert. Es zeigen
Fig. 1 schematisch den seitlichen Schnitt durch eine erfindungsgemässe Umladevorrichtung im Beschickungszustand;
Fig. 2 schematisch den Schnitt nach Figur 1 im Beresp. Entladungszustand;
Fig. 3 die schematische Seitenansicht der erfindungsgemässen Greifmittel beim Ergreifen des Magazins;
Fig. 4 die schematische Seitenansicht nach Figur 3 nach dem Verschwenken des Magazins;
Fig. 5 die Vorderansicht einer erfindungsgemässen Greifvorrichtung im Bereich des Magazins,
Fig. 6 den Längsschnitt durch den Grundkörper der Greifvorrichtung nach Fig.5;
Fig. 7 den Längsschnitt durch einen erfindungsgemäss ausgestalteten Auslegearm der Greifvorrichtung; und
Fig. 8 den Querschnitt durch das Anschlagelement der Greifvorrichtung.

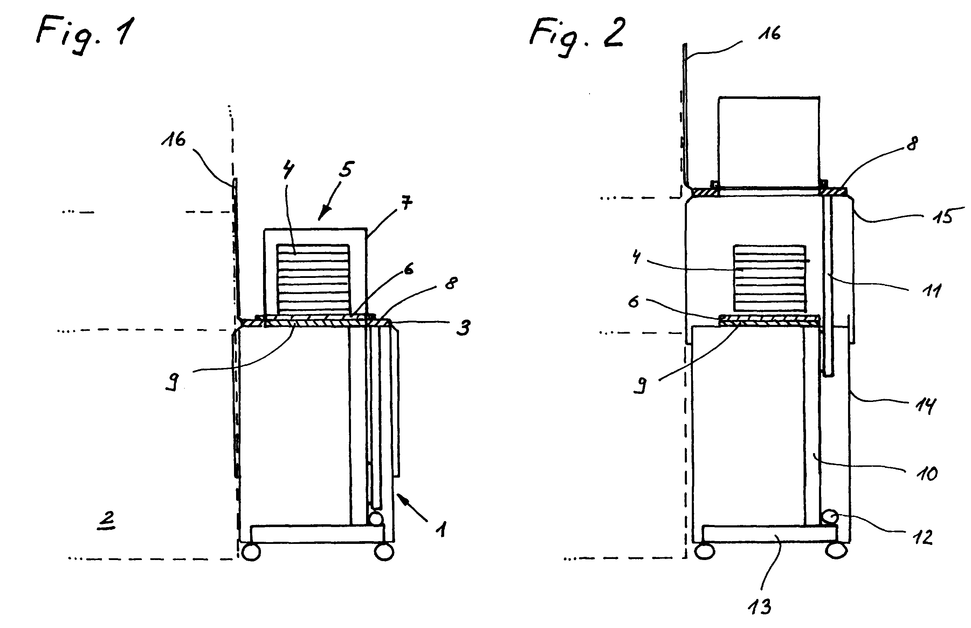

Figur 1 zeigt den seitlichen Schnitt durch eine erfindungsgemässe Umladevorrichtung 1, welche an eine rein schematisch durch eine gestrichelte Linie dargestellte Bearbeitungsanlage 2 angekoppelt ist. Die Ankoppelung der Umladevorrichtung 1 an die Bearbeitungsanlage erfolgt mittels herkömmlicher Befestigungsmittel (nicht dargestellt), beispielsweise mittels lösbaren Befestigungsbolzen.

Auf die Beschickungsplattform 3 der Umladevorrichtung 1 ist eine ein Magazin 4 enthaltende Box 5 aufgelegt. Diese Box 5 ist vorzugsweise als standardisierte SMIF (Standard Mechanical Interface) ausgeführt. Derartige Boxen werden für die Aufnahme von Wafer verwendet, welche bis zum Abschluss der Herstellungs- resp. Bearbeitungsprozesses unter Reinraumbedingungen bearbeitet und transportiert werden müssen. Diese Box 5 weist einen Boden 6 und eine Haube 7 auf. Der Boden 6 und die Haube 7 sind im verschlossenen Zustand miteinander über einen lösbaren Verriegelungsmechanismus verbunden. Nach dem Aufsetzen der Box 5 auf die Plattform 3 wird der Rand der Haube 7 mit dem Rahmen 8 der Plattform 3 verbunden und der Verriegelungsmechanismus von Boden 6 und Haube 7 gelöst. Damit kann nun erfindungsgemäss der Rahmen 8 zusammen mit der Haube 7 nach oben angehoben werden, wobei der Boden 6 und damit das darauf befindliche Magazin 4 auf der Bodenplatte 9 der Plattform 3 in der jetzigen Position verbleiben, wie in Figur 2 dargestellt.

Das Anheben erfolgt beispielsweise mittels einer in einer Führungsschiene 10 vertikal verschiebbar gelagerten Hebestange 11, welche mit dem Rahmen 8 verbunden ist. Angetrieben wird die Hebestange 11 vorzugsweise mittels eines Servomotors 12, welcher am Gehäuserahmen 13 der Umladevorrichtung 1 angeordnet ist.

Die Umladevorrichtung 1 weist im unteren Bereich um den Gehäuserahmen 13 eine Gehäusewandung 14 auf. Am beweglichen Rahmen 8 ist ebenfalls eine, die Geäusewandung 14 teleskopartig umschliessende Abdeckung 15 angeordnet, welche gegen die Bearbeitungsanlage 2 hin eine Durchlassöffnung aufweist, damit das Magazin 4 von der Umladevorrichtung 1 zum Aufnahmebereich der Bearbeitungsanlage 2 transportiert werden kann. Damit die Öffnung des Aufnahmebereichs der Bearbeitungsanlage 2 auch in der in Figur 1 dargestellten Beschickungsposition nach Aussen geschlossen ist, ist am Rahmen 8 weiter eine Abdeckplatte 16 angeordnet, welche sich von der Plattform 3 aus nach oben erstreckt und die genannte Öffnung des Aufnahmebereiches in dieser Stellung abdeckt.

Der Vorteil dieser erfindungsgemässen Lösung liegt insbesondere darin, dass im Vergleich zu den Eingangs genannten bekannten Lösungen nach dem Beschicken der Umladevorrichtung 1 nur noch ein einziger Hubvorgang notwendig ist, um danach unmittelbar das Magazin 4 mittels einer Greifeinrichtung zu erfassen und der Bearbeitungsanlage zuzuführen. Dies führt einerseits zu einer kürzeren Umladezeit, was zu einer höheren Bearbeitungsrate der Wafer führt und damit auch zu tieferen Produktionskosten bei grösserem Durchsatz. Andererseits führen die geringeren Bewegungsabläufe auch zu weniger Verschleiss und einer geringeren Störungsanfälligkeit der Umladevorrichtung 1. Schliesslich werden die Ergonomie- und die Reinraumanforderungen vollumfänglich erfüllt. Ebenfalls ist von Vorteil, dass das Magazin 4 mit den Wafern beim Vorgang praktisch nicht bewegt wird, wodurch allfällige Beschädigungen infolge von Vibrationen beim Hochheben und Absenken der gesamten Box 5 praktisch vollständig vermieden werden können.

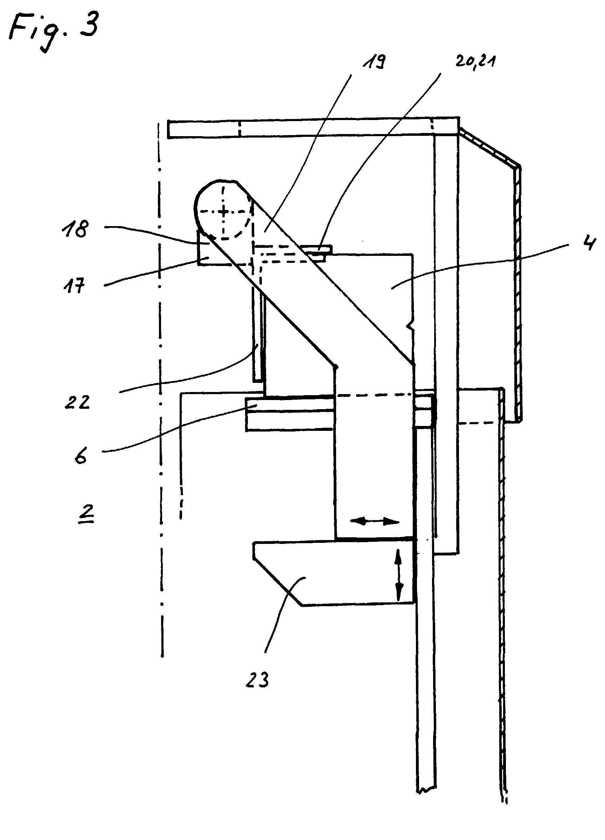

Aufgrund der erfindungsgemässen Ausführung der Umladevorrichtung 1 lässt sich besonders vorteilhaft ein ebenfalls erfindungsgemäss ausgestaltete Greifvorrichtung 17 einsetzen, wie schematisch in Figur 3 dargestellt ist. Der Übersichtlichkeit halber ist in dieser Figur die Darstellung des Deckels 7 der Box 3 weggelassen. Die Greifvorrichtung 17 besteht erfindungsgemäss aus einem Grundkörper 18, welcher vorzugsweise beidseitig in einem Auslegerarm 19 drehbar gelagert angeordnet ist, und davon herausragenden, vorzugsweise im rechten Winkel zueinaner angeordneten Haltefingern 20, 21 und Anschlagselement 22.

Vorzugsweise sind zwei, beidseits des Magazins 4 angeordnete Auslegerarme 19 vorgesehen. Diese Auslegearme sind horizontal verschiebbar auf einer Konsole 23 gelagert, welche ihrerseits vertikal verschiebbar beispielsweise an der Führungsschiene 10 angeordnet ist. Die Bewegungsrichtungen sind in der Figur durch Pfeile an der Konsole 23 resp. am Auslegerarm 19 angedeutet.

In der dargestellten Position ist der Auslegerarm 19 resp. die Konsole 23 derart bewegt resp. verschoben worden, dass die Haltefinger 20, 21 seitlich mit dem Magazin in Eingriff gelangen. Gleichzeitig gelangt das Anschlagselement 22 an der vorderen, offenen Seite des Magazins 4 mit den Rändern der darin gestapelten Wafern in Anschlag.

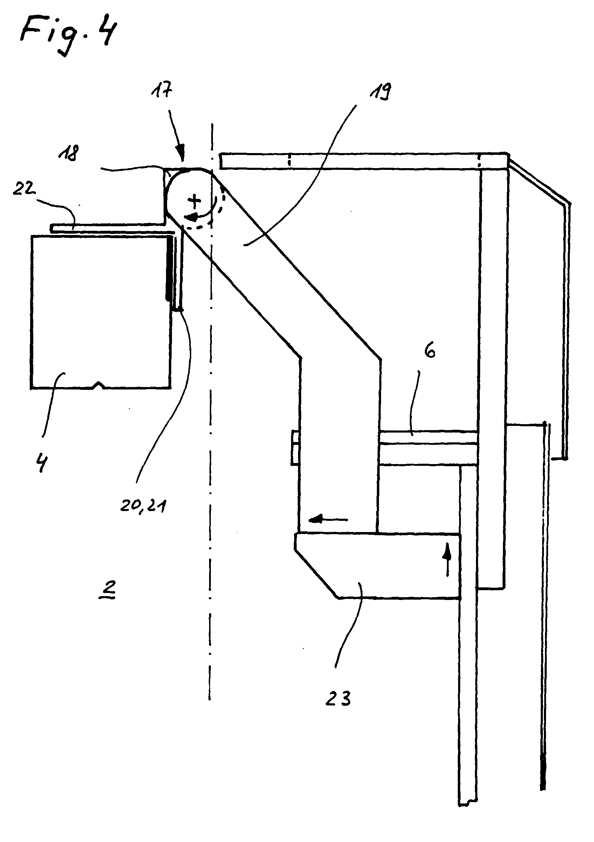

Nun kann das Magazin 4 durch Verfahren der Konsole 23 und der Auslegerarme 19 vom Boden 6 abgehoben werden und dem Beladeraum der Bearbeitungsanlage 2 zugeführt werden (durch die strichpunktierte Linie dargestellt), wie in Figur 4 dargestellt. Ebenfalls kann nun der Grundkörper 18 der Greifvorrichtung 17 vorzugsweise um 90° verschwenkt werden, um das Magazin 4 in die geforderte Lage und Ausrichtung zu positionieren. In dieser Lage können die Wafer mittels herkömmlicher Transportmitteln, wie beispielsweise parallel zueinander angeordnete Rollen (nicht dargestellt), für die Bearbeitung innerhalb der Bearbeitungsanlage 2 aus dem Magazin 4 herausgehoben werden und danach diesem wieder zugeführt werden. Die Rückführung des Magazins 4 auf den Boden 6 erfolgt schliesslich in umgekehrter Weise wie vorgängig beschrieben.

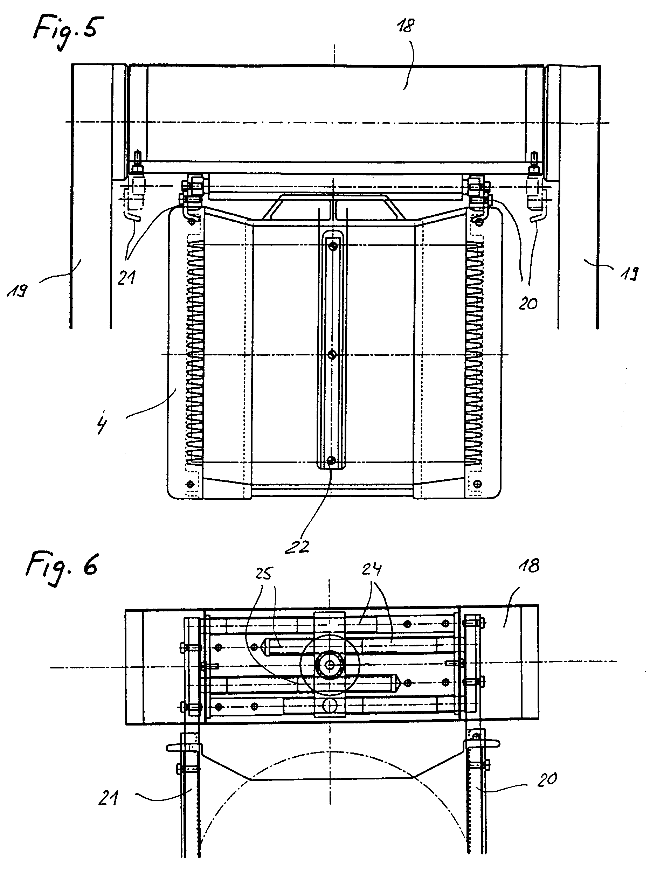

In Figur 5 ist die Vorderansicht des Bereichs der Greifvorrichtung 17 der Umladevorrichtung 1 dargestellt. Klar erkennbar ist hier die beidseitige Lagerung der Grundkörpers 18 in den beiden seitlich des Magazins 4 angeordneten Auslegerarme 19. Die beiden Haltefinger 20, 21 sind ausgezogen in der mit dem Magazin 4 in Eingriff stehenden Lager dargestellt. In dieser Lage kann das Magazin 4 durch die Auslegerarme 19 bewegt resp. durch drehen des Grundkörpers 18 verschwenkt werden. Damit die im Magazin 4 gestapelten Wafer nicht herausfallen oder sich verrücken können, ist weiter das Anschlagselement 22 vorhanden, welches gegen die offene Seite des Magazins 4 an die Ränder der Wafer in Anschlag gebracht wird und diese damit in ihrer Lage fixiert. Vorteilhaft ist dabei auch, dass sich die Wafer auch nicht durch Erschütterungen, welche durch die Bewegung der Auslegerarme 19 resp. beim Drehen des Grundkörpers 19 auftreten könnten, bewegt werden können. Solche Bewegungen können zu störenden Klappergeräuschen führen. Die erfindungsgemässe Greifvorrichtung 17 eignet sich besonders vorteilhaft für schnelle Bewegungen, was neben dem vereinfachten Bewegungsablauf der Plattform 3 der Umladevorrichtung 1 mit zu einer Steigerung der Umladegeschwindigkeit und damit zu einer Steigerung der Produktivität der Vorrichtung führt.

Um die Greifvorrichtung 17 überhaupt an das Magazin 4 in Anlage zu bringen, sind die Haltefinger 20 und 21 seitlich verschiebbar, wie besonders deutlich aus der Schnittdarstellung des Grundkörpers 18 in Figur 6 hervorgeht, resp. wie die gestrichtelt dargestellte Lager der Haltefinger 20, 21 in Figur 5 zeigt. Diese Verschiebung wird vorzugsweise mittels Pneumatikzylinder 24 bewirkt, welche im Grundkörper 18 angeordnet sind. In diesen Pneumatikzylindern 24 sind Kolben 25 angeordnet, welche mit den Haltefingern 20 und 21 verbunden sind und die Bewegung auf diese übertragen. Die pneumatische Ansteuerung erlaubt sehr schnelle Bewegungsabläufe und starke Haltekräfte für das Magazin 4.

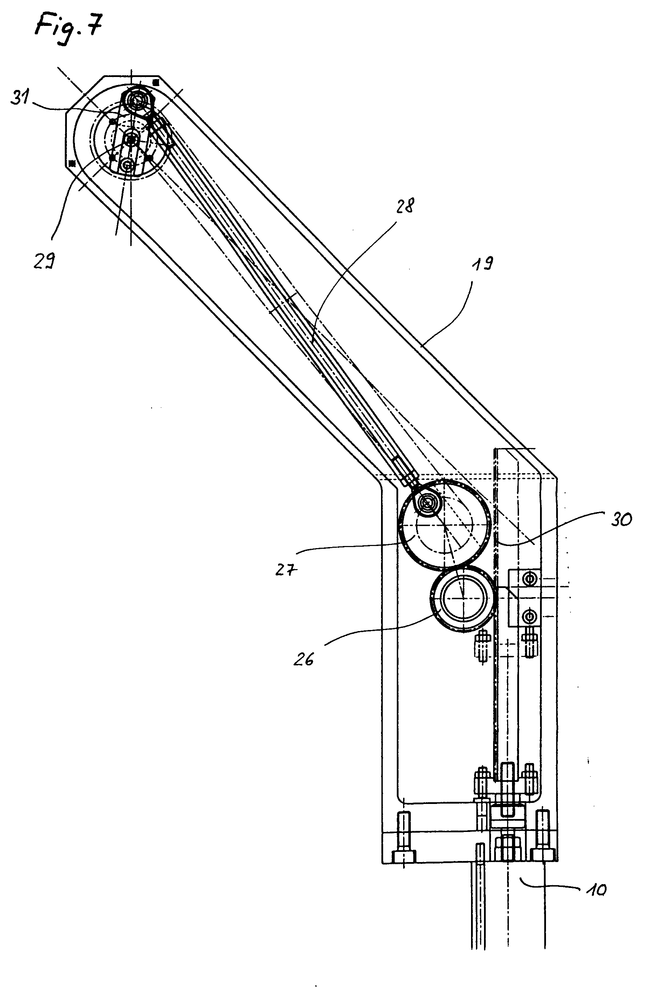

In Figur 7 ist der Längsschnitt durch einen Auslegerarm 19 in bevorzugter Ausführungsform dargestellt. In dieser Ausführungsform wird die Drehbewegung des Grundkörpers 17 nicht durch einen eigenen Antrieb ausgeführt, sondern über Zahnräder 26, 27 und einer Stange 28 auf die Achse 29 des Grundkörpers 17 erfolgt. Das Zahnrad 26 greift hierbei in eine an der Führungsschiene 10 befindliche Zahnstange 30 ein und wird bei einer vertikalen Verschiebung des Auslegearmes 19 gegenüber der Führungsschiene 10 verdreht. Die Drehbewegung wird über das weitere Zahnrad 27 und die Stange 28 zur Achse 29 des Grundkörpers 17 übertragen und verschwenkt diesen. Selbstverständlich eignet sich hierfür auch jede andere bekannte mechanische Uebertragung einer translatorischen Bewegung in eine Drehbewegung. Vorteilhafterweise muss der Antrieb nur in einem der beiden Auslegearme 19 vorhanden sein. Durch diese Ausgestaltung wird vorteilhafterweise das Vorsehen eines zusätzliches Antriebsmittel, beispielsweise eines zusätzlichen Antriebsmotors, für die Drehbewegung der Greifvorrichtung 17 vermieden.

Als Antriebsmittel für die Hubbewegung des Rahmens 6 resp. der Konsole 23 wird erfindungsgemäss vorzugsweise ein Servomotor eingesetzt. Derartige Motoren weisen ein für diese Anwendung ideales Verhalten auf, indem die Bewegung einerseits sehr präzise und auf immer wieder dieselbe Position eingestellt werden kann und andererseits eine langsam ansteigende Beschleunigung und Verlangsamung der Bewegung eingestellt werden kann. Dadurch werden ruckartige Bewegungen verhindert, welche Erschütterungen der Wafer im Magazin 4 hervorrufen könnten, welche nicht erwünscht sind. Vorzugsweise wird die vertikale Bewegung von Konsole 23 und Rahmen 6 durch denselben Antriebsmotor erzeugt, welche für die entsprechende Bewegung jeweils in den Antriebsstrang eingekoppelt wird.

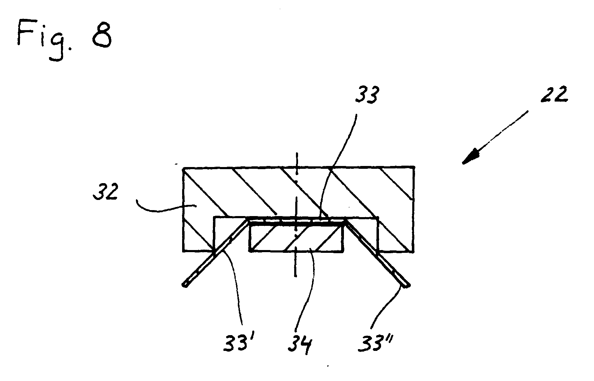

In Figur 8 ist schliesslich noch der Querschnitt durch das Anschlagelement 22, wie in Figur 5 in der Ansicht dargestellt, gezeigt. Vorzugsweise ist es aus einem eine Nut aufweisenden Stange 32 gebildet, in welcher ein aus einem elastischen Material bestehendes, flaches Band 33 befestigt ist. Die Befestigung erfolgt beispielsweise mittels eines Befestigungsbandes 34, welches durch das Band 33 hindurch mit der Stange 32 beispielsweise verschraubt sein kann. Durch diese Befestigungsart werden die beiden seitlichen Kanten 33' und 33'' des flachen Bandes 33 in einem Winkel nach Aussen von der Stange abstehend ausgebogen. Damit können die beiden Kanten 33' und 33'' in vorteilhafter Weise mit den Rändern der gestapelten Wager in Anschlag gebracht werden. Das Anschlagelement 22 ist dabei vorteilhafterweise eigenständig bewegbar im Grundkörper 18 angeordnet.

Die Umladevorrichtung 1 ist in den dargestellten Ausführungsbeispiel als Einzelvorrichtung zum Be- und Entladen einer einzelnen Box 5 dargestellt. Die erfindungsgemässe Ausgestaltung der Vorrichtung eignet sich aber vorzugsweise auch für das gleichzeitige Be- und Entladen von mehreren Boxen 5. Hierfür wird die Umladevorrichtung 1 breiter ausgeführt und parallel nebeneinander mehrere Plattformen 6 mit mehreren Greifvorrichtungen 17 in einem Gehäuse angeordnet. Vorteilhafterweise kann dann ein einzelner Antriebsmotor 12 für die Hubbewegungen auch mehrerer Konsolen 23 und Rahmen 8 verwendet werden, indem die Antriebsstränge gekoppelt werden.

## Patentansprüche

1. Umladevorrichtung (1) für Wafer, die in einer einen Boden (6) und einen haubenförmigen Deckel (7) aufweisenden Box (5) in einem Magazin (4) gestapelt angeordnet sind, um einer Bearbeitungsanlage (2) zugeführt zu werden, wobei die Umladevorrichtung (1) wenigstens eine Beschickungsplattform (3) für die Aufnahme der Box (5) und Greifmittel (17;18-21) für das Ergreifen, Verschwenken und Transportieren des Magazins (4) aufweist, dadurch gekennzeichnet, dass die Beschickungsplattform (3) eine Bodenplatte (9), auf welcher der Boden (6) der Box (5) aufliegt, in einem vertikal mittels eines Antriebs (12) verfahrbaren Rahmen (8), auf welchem der Deckel (7) aufliegt, aufweist, wobei der Rahmen (8) eine sich nach unten erstreckende, die Umladevorrichtung (1) umfassende Abdeckung (15) aufweist, welche in der angehobenen Position des Rahmens (8) einen Reinraum über dem Bereich der Bodenplatte (9) bildet.

2. Umladevorrichtung nach Anspruch 1, dadurch gekennzeichnet, dass das Antriebsmittel (12) ein Linearmotor resp. ein Servomotor ist.

3. Umladevorrichtung nach Anspruch 1 oder 2, dadurch gekennzeichnet, dass die Greifmittel (17) zwei seitlich an das Magazin angreifbare Haltefinger (20,21) aufweisen, welche seitlich verschiebbar in einem drehbar gelagerten Greifkörper (18) angeordnet sind.

4. Umladevorrichtung nach Anspruch 3, dadurch gekennzeichnet, dass im Greifkörper (18) pneumatisch betreibbare Kolben (25) in Zylindern (24) angeordnet sind, welche mit den Haltefingern (20,21) verbunden sind.

5. Umladevorrichtung nach Anspruch 3 oder 4, dadurch gekennzeichnet, dass der Greifkörper (17) in mindestens einem seitlich der Box angeordneten Ausleger (19) gelagert ist, welcher horizontal wie vertikal bewegbar in der Umladevorrichtung (1) angeordnet ist.

6. Umladevorrichtung nach Anspruch 5, dadurch gekennzeichnet, dass zwei Ausleger (19) jeweils zu beiden Seiten des Magazins (4) angeordnet sind und dass der Greifkörper (17) in beiden Auslegern (19) gelagert angeordnet ist.

7. Umladevorrichtung nach einem der Ansprüche 5 bis 6, dadurch gekennzeichnet, dass der Greifkörper (17) mechanisch derart mit mindestens einem Ausleger (19) gekoppelt ist, dass bei der Vertikalbewegung des Auslegers (19) bezüglich der Umladevorrichtung (1) der Greifkörper (17) um seine Lagerachse (29) verschwenkt wird.

8. Umladevorrichtung nach Anspruch 7, dadurch gekennzeichnet, dass die mechanische Koppelung mittels Stangen (28), Zahnrädern (26,27) und Zahnstangen (30) ausgeführt ist.

9. Umladevorrichtung nach einem der Ansprüche 1 bis 8, dadurch gekennzeichnet, dass ein einzelner Antrieb (12) sowohl für die vertikale Bewegung der Greifmittel (17) wie für das Anheben resp. Absenken des Rahmens (8) der Beschickungsplattform (3) vorhanden ist.

10. Umladevorrichtung nach einem der Ansprüche 1 bis 9, dadurch gekennzeichnet, dass die Greifmittel (17) mindestens ein an die Wafer-Ränder der offenen Seite des Magazins (4) in Anschlag bringbares Anschlagelement (22) aufweisen, vorzugsweise in Form einer Anschlagstange.

11. Umladevorrichtung nach Anspruch 10, dadurch gekennzeichnet, dass das Anschlagelement (22) aus einer formfesten Stange besteht, welche zwei parallel zueinander angeordnete, nach Aussen vorstehende Lippen aus elastischem Material aufweist.

12. Umladevorrichtung nach Anspruch 11, dadurch gekennzeichnet, dass die Lippen durch die Seitenkanten eines flachen Bandes aus elastischem Material gebildet werden, welches mittels eines Befestigungsbandes in einer Nut der Stange befestigt ist.

13. Verfahren zum Umladen von in Magazinen (4) gestapelten Wafern von einer Umladevorrichtung (1) in eine Bearbeitungsanlage (2), wobei die Magazine (4) in mit einer abnehmbaren Haube (7) versehenen Box (5) gelagert sind und der Umladevorrichtung (1) in horizontaler Ausrichtung zugeführt werden, dadurch gekennzeichnet, dass die Box (5) auf der Be- resp. Entladeebene der Umladevorrichtung (1) zugeführt und auf eine Plattform aufgebracht wird, dass anschliessend der Deckel (7) der Box (5) vom Boden (6) gelöst resp. entriegelt wird und danach mittels eines Rahmens (8) vertikal nach oben vom Boden (6) weggehoben wird, anschliessend Greifmittel (17) in Anschlag mit dem Magazin (4) gebracht werden und das Magazin (4) vom Boden (6) weggehoben und der Bearbeitungsanlage (2) zugeführt wird, und dass der Entladevorgang nach der Bearbeitung der Wafer entsprechend umgekehrt vorgenommen wird.

14. Verfahren nach Anspruch 13, dadurch gekennzeichnet, dass gleichzeitig mit dem Wegheben resp. Rückführen des Magazins (4) auf den Boden (6) eine Dreh- resp. Schwenkbewegung des Magazins (4) ausgeführt wird.
